# EUROPÄISCHE PATENTSCHRIFT

(11) **EP 1 382 411 B1**
(45) Veröffentlichungstag und Bekanntmachung des Hinweises auf die Patenterteilung: **05.10.2011**
(21) Anmeldenummer: 03015282.1
(22) Anmeldetag: 07.07.2003
(51) Int. Cl.: B23K 15/00, H01J 37/304, G01T 1/28

(54) **Verfahren zum Vermessen des Intensitätsprofils eines Elektronenstrahls, insbesondere eines Strahls eines Elektronenstrahlbearbeitungsgeräts, und/oder zum Vermessen einer Optik für einen Elektronenstrahl und/oder zum Justieren einer Optik für einen elektronenstrahl, Messstruktur für ein solches Verfahren und Elektronenstrahlbearbeitungsgerät**
Method of measuring the intensity profile of an electron beam, particularly of a beam of an electron beam processing device, and/or measuring of an optics for an electron beam and/or adjusting of an optics for an electron beam, measuring structure for such a method and electron beam processing device
Procédé de mesure du profil d'intensité d'un faisceau d'électrons,notamment d'un faisceau d'un dispositif d'usinage par faisceau d'électrons,et/ou de mesure d'une optique pour un faisceau d'électrons et/ou d'ajustage d'une optique pour un faisceau d'électrons,structure de mesure pour un tel procédé et dispositif d'usinage par faisceau d'électrons

(30) Priorität: 17.07.2002 DE 10232230
(43) Veröffentlichungstag der Anmeldung: 21.01.2004
(73) Patentinhaber: pro-beam AG & Co. KGaA, 82152 Planegg (DE)
(72) Erfinder: Löwer, Thorsten, 63636 Brachttal (DE)
(74) Vertreter: Ostertag, Reinhard

(56) Entgegenhaltungen:
- EP-A- 0 242 993
- DE-A- 1 589 936
- DE-A- 3 718 177
- DE-A- 10 129 019
- GB-A- 2 132 390
- US-A- 3 752 952

## Beschreibung

Die Erfindung betrifft ein Verfahren zum Vermessen des Intensitätsprofils eines Elektronenstrahls, insbesondere eines Strahls eines Elektronenstrahlbearbeitungsgeräts, und/oder zum Vermessen einer Optik für einen Elektronenstrahl und/oder zum Justieren einer Optik für einen Elektronenstrahl, eine Meßstruktur für ein solches Verfahren und ein Elektronenstrahlbearbeitungsgerät.

In der vorliegenden Beschreibung und den Ansprüchen soll unter Optik für einen Elektronenstrahl eine beliebige Anordnung verstanden werden, welche die Geometrie des Strahlquerschnittes eines Elektronenstrahles und/oder die Ausrichtung der Strahlachse eines Elektronenstrahles beeinflussen kann. Es sind dies in der Praxis elektrische und/oder magnetische optische Komponenten, insbesondere elektrische und/oder magnetische Linsen, Stigmatoren und Ablenker.

Eine Optik kann durch eine einzige solche Komponente gebildet sein oder meherer solche Komponenten umfassen.

Um z.B. beim Elektronenstrahlschweißen Schweißnähte mit gleichbleibender und bekannter Güte erzeugen zu können, ist es von Vorteil, wenn man das Intensitätsprofil des im Elektronenstrahlschweißgerät verwendeten Elektronenstrahls kennt und möglichst unmittelbar vor dem Prozeß vermessen kann.

Auch die Kenntnis der Abbildungseigenschaften einer Strahl-Optik des Elektronenstrahlbearbeitungsgeräts und die Möglichkeit, Strahlquerschnitt und Abbildungseigenschaften automatisch auf Sollwerte einzuregeln wären für das Bearbeiten von Werkstücken mit Elektronenstrahlschweißen von Vorteil.

Üblicherweise erfolgt die Vermessung des Intensitätsprofils eines Elektronenstrahls so, daß nacheinander bekannte Teile des Elektronenstrahls in einen Auffänger, insbesondere einen Faraday-Käfig geleitet wird. Wie im Buch von Schultz "Elektronenstrahlschweißen", Fachbuchreihe Schweißtechnik, DVS-Verlag auf den Seiten 15 bis 20 beschrieben, können verschiedenartige Meßkörper eingesetzt werden, um einen Teil des Strahls in den Auffänger zu leiten, wobei der Elektronenstrahl mittels eines Magnetfelds relativ zu dem Meßkörper ausgelenkt wird, so daß nacheinander verschiedene Querschnittsteile des Elektronenstrahls in den Auffänger gelangen.

Der einfachste solche Meßkörper umfaßt eine Schwellenkante. Zwei gegenüberliegende derartige Meßkörper bilden eine Meßstruktur mit einer Schlitzblende, hinter der der durchgetretene Teil des Strahles durcj einen dort liegenden Sensor gemessen wird. Durch eine solche Meßstruktur kann das Strahlprofil in einer Richtung vermessen werden. Mittels einer Lochblende kann das Intensitätsprofil eines Elektronenstrahls auch in einer zweiten Richtung dazu vermessen werden, wobei der Elektronenstrahl Teilstrahl für Teilstrahl nacheinander über das Loch geleitet wird, mittels des o. g. Magnetfelds, wobei die Steuertechnik aus der Rasterelektronenmikroskopie bekannt ist.

Ein Nachteil im Stand der Technik besteht darin, daß ein auf der Achse der Elektronenkanone (nachstehend kurz: Strahlhauptachse) angeordneter Auffänger an der Stelle in einem Elektronenstrahlbearbeitungsgerät Platz wegnimmt, wo das Werkstück angeordnet wird. Ein abzweigend vom eigentlichen elektronenstrahlengang in einem zweiten Strahlengang angeordneter auffänger (Sensor) braucht zusätzlichen Platz. Auch hat man in diesem Falle für die Messung der Intensitätsprofile nicht exakt dieselben Verhältnisse wie beim späteren Schweißen.

Die DE 101 29 019 A1 zeigt eine Elektronenstrahl-Belichtungsvorrichtung, bei der ein metallisches Streifenmuster mit einer kleinen Linienbreite als Meßstruktur verwendet wird. Dabei werden rückgestreute Elektronen ausgewertet.

Es ist Aufgabe der Erfindung, bei kompakter Bauweise des Gerätes eine Elektrorienatrahlvermessung mit einer höheren Auflösung zu ermöglichen.

Diese Aufgabe ist gelöst durch ein Verfahren mit den im Anspruch 1 aufgeführten Merkmalen.

Erfindungsgemäß wird der Elektronenstrahl durch eine Relativbewegung zu einer Meßstruktur auf verschiedene stellen von dieser geleitet, die unterschiedliche Rückstreueigenschaften aufweisen und der Elektronenstrom der Rückstreuelektronen wird in Abhängigkeit von der Relativbewegung von Elektronenstrahl und Meßstruktur gemessen.

unter Rückstreuelektronen wird im Rahmen der vorliegenden Anmeldung jedes von einer Oberfläche mit einer Komponente in Gegenrichtung zur eigentlichen Elektronenausbreitung zurückgesandte Elektronen verstanden, d.h. Rückstreuelektronen im engeren Sinne und Sekundärelektronen.

Dadurch, dass die Rückstreuelektronen gemessen werden, kann ein entsprechender Sensor, beispielsweise ein Sensorring, um den Elektronenstrahl herum in der Nähe der ohnehin vorhandenen Auslenkmagnete angeordnet werden, ohne daß zusätzlicher Platz benötigt wird.

Bei einigen Elektronenstrahlbearbeitungsgeräten ist ohnehin vorgesehen, daß ein zu bearbeitendes Werkstück mittels einer Rasterelektronen-Bilderzeugungsfunktion vor dem Bearbeiten betrachtet werden kann. In diesem Falle ist es von besonderem Vorteil, die Erfindung einzusetzen, weil zur Bildgebung dieselben Sensoren verwendet werden können, wie sie als Rückstreuelektronenmeßgeräte dienen.

Ein weiterer Vorteil des erfindungsgemäßen Verfahrens ist der, dass zu seiner Durchführung nur eine passive Meßstruktur zusätzlich benötigt wird, so daß zum Meßraum keine zusätzlichen elektrischen Leitungen verlegt werden müssen, was bei für die Serienfertigung dienenden Elektronenstrahl-Schweißgeräten, bei denen die Werkstücke auf Paletten angeordnet ein- und ausgeschleust werden, mit Schwierigkeiten verbunden wäre.

Bei der Verwendung einer Öffnung streut der transmittierende Teil der Meßstruktur, also die Öffnung, nicht zurück. Der Rest der Meßstruktur streut hingegen zumindest schwach zurück.

Bei der Verwendung einer Rückstreufläche erhält man einen besonders guten Kontrast zwischen den durch den Meßkörper rückgestreuten Elektronen, die zum Ausmessen des Querschnittsprofils des Elektronenstrahls verwendet werden, und diffus von der Oberfläche einer Basis der Meßstruktur etwa rückgestreuten Elektronen.

Da die Öffnungen und Rückstreuflächen kreisförmig sind, verhalten sich diese isotrop, d.h. man kann in beliebiger Richtung über sie hinwegfahren, ohne daß richtungsabhängige Korrekturen der Meßsignale notwendig wären.

Insgesamt kann das Meßverfahren dadurch mit einer hohen Auflösung durchgeführt werden.

Vorteilhafte Weiterbildungen der Erfindung sind in Unteransprüchen angegeben.

Auch die Weiterbildung der Erfindung gemäß Anspruch 2 ist im Hinblick auf guten Kontrast bei der Ausmessung des Querschnittsprofilas von Vorteil.

Ist die zum Ausmessen des Strahlquerschnitts dienende Rückstreufläche von der Oberseite einer Basis der Meßstruktur beabstandet, wie im Anspruch 3 angegeben, wirkt sich dies ebenfalls günstig auf die Präzision der Messung und den Kontrast der Querschnittsmessung aus.

Die.Weiterbildung der Erfindung gemäß Anspruch 4 ist im Hinblick auf niedere Herstellungskosten für kleine Rückstreuflächen und im Hinblick auf guten Kontrast von Vorteil.

Auch die Weiterbildung gemäß Anspruch 5 dient einer Verbesserung des Ruckstreuverhaltens der Rückstreufläche.

Mit der Weiterbildung der Erfindung gemäß Anspruch 6 wird erreicht, daß hinter der Rückstreuflächen liegende Umfangsabschnitte der Nadel nicht zu zusätzlichen rückgestreuten Elektronen führen, was den Kontrast des Meßverfahrens beeinträchtigen würde.

Gemäß Anspruch 7 werden die rückgestreuten Elektronen auf sehr einfache Weise gemessen. Entsprechende Sensorringe sind auch in solchen Elektronenstrahlbearbeitungsgeräten oft schon vorhanden, bei denen auch die Möglichkeit zur rasterelektronischen Bilderzeugung einer Werkstückoberfläche besteht.

Im Prinzip kann man die Relativbewegung zwischen Elektronenstrahl und Meßstruktur sowohl durch eine Bewegung der Meßstruktur als auch durch eine Bewegung des Elektronenstrahles (als auch durch eine Bewegung von Elektronenstrahl und Meßstruktur) erzeugen- Die im Anspruch 8 angegebene Art der Erzeugung der Relativbewegung läßt sich aber ohne mechanische Mittel und sehr rasch durchführen und ermöglicht auch die Bestimmung der Qualität der Strahlablenkung durch die Optik.

Verwendet man bei dem Verfahren zum Bestimmen des Intensitätsprofiles eines Elektronenstrahles eine Meßstruktur, wie sie im Anspruch 9 angegeben ist, so kann man das Intensitätsprofil gleichzeitig für eine Mehrzahl unterschiedlicher Auslenkungswinkel des Elektronenstrahles messen. Auf diese Weise läßt sich ermitteln, ob und in welchem Ausmaße das Intensitätsprofil von der Ablenkung des Elektronenstrahles abhängt.

Dabei kann man mit dem Verfahren gemäß Anspruch 10 das Intensitätsprofil innerhalb eines vorgegebenen Gesamt-Ablenkungsbereiches für den Elektronenstrahl an verschiedenen gleichförmig über den Ablenkbereich verteilten Stellen messen.

Dabei ist mit der Weiterbildung gemäß Anspruch 11 gewährleistet, daß die Rückstreuflächen jeweils senkrecht zur mittleren Richtung des Elektronenstrahles ausgerichtet sind.

Bei dem Verfahren gemäß Anspruch 12 wird das Intensitätsprofil des Elektronenstrahles in zwei zueinander senkrechten Richtungen gemessen, so daß man eine vollständige flächenhafte Information über die Energiedichte im Elektronenstrahl hat. Macht man dies für unterschiedliche Fokussierungsbedingungen (Ändern der Bestromung der Fokussierlinse) oder unterschiedliche Stellung der Meßstruktur auf der Strahlachse, so erhält man eine komplette räumliche Strahl-Tomographie.

Die weiterbildung der Erfindung gemäß Anspruch 13 ist wiederum im Hinblick darauf von Vorteil, einerseits für die rückstreuenden Oberflächen oder die größere Durchlässigkeit aufweisenden Oberflächen den notwendigen mechanischen Halt zu schaffen, andererseits aber zu verhindern, daß der mechanische Halt für die Oberflächenunregelmäßigkeiten bezüglich der Absorption/Rückstreuung in nennenswertem Maße zu unerwünschten gestreuten Elektronen führt.

Das Verfahren gemäß Anspruch 14 gestattet es, unter Verwendung einer regelmäßigen Meßstruktur, die an sich für die Vermessung des Intensitätsprofiles eines Elektronenstrahles gedacht war, zugleich auch die Abbildungseigenschaften der Elektronenstrahl-Optik zu messen.

Mit dem im Anspruch 20 angegebenen Verfahren kann man sich auf einfache Weise ein einfach auswertbares Gesamtbild über die Abbildungseigenschaften der Optik verschaffen.

Gemäß Anspruch 21 kann man automatisch den Elektronenstrahl so fokussieren, daß der Querschnitt des Elektronenstrahles ein Minimum annimmt.

Die im Anspruch 22 angegebene Meßstruktur hat einen mechanisch besonders einfachen Aufbau.

Die Weiterbildung der Meßstruktur gemäß Anspruch 23 dient wieder dazu, Verfälschungen des Meßergebnisses durch geometrische Effekte zu vermeiden.

Eine Meßstruktur gemäß Anspruch 24 zeichnet sich durch mechanisch besonders einfachen Aufbau und guten Kontrast aus.

Dabei erhält man gemäß Anspruch 25 auf einfache Weise präzise räumlich orientierte und gut rückstreuende Rückstreuflächen.

Die Weiterbildung der Erfindung gemäß Anspruch 26 gewährleistet wieder, daß die Rückstreuflächen auf einfache Weise zuverlässig und bleibend im Raum orientiert werden, ohne daß die hierzu verwendeten mechanischen Mittel zu unerwünschten rückgestreuten Elektronen führen.

Die Weiterbildung der Erfindung gemäß Anspruch 27 schafft eine Meßstruktur, die wieder zum Messen des Querschnittsprofiles eine Elektronenstrahles für unterschiedliche Auslenkungswinkel geeignet ist und eine einfache Auswertung des Stromes rückgestreuter Elektronen ermöglicht.

Bei einer Meßstruktur, wie sie im Anspruch 28 angegeben ist, kann man einerseits auf einfache Weise die Abbildungseigenschaften der Elektronenstrahl-Optik testen (über die Gitterlinien) und zugleich auch die Intensitätsprofile des Elektronenstrahles für unterschiedliche Auslenkwinkel einfach ermitteln (über die Rückstreuflächen).

Der Anspruch 29 betrifft eine Meßvefahren, mit welchem aus dem Strom der durch die Meßstruktur hindurchtretenden Elektronen der Strahlquerschnitt und/oder die Abbildungseigenschaften der Optik ermittelt werden.

Die Ansprüche 30 bis 33 betreffen Elektronenstrahl-Bearbeitungsgeräte, bei denen auf einfache Weise das Intensitätsprofil des Elektronenstrahles und die Abbildungseigenschaften der Optik für den Elektronenstrahl gemessen werden können.

Die Weiterbildungen gemäß Anspruch 34 und 35 sind im Hinblick auf scharfe und kontrastreiche Abbildung kleiner bzw. ausgedehnter Rückstreuflächen einer Meßstruktur von vorteil.

Bei einem erfindungsgemäßen Verfahren, mit dem die Güte der Optik des Elektronenstrahlbearbeitungsgerätes bestimmt wird, werden die Sensoren zum Messen der Rückstreuelektronen so verwendet, daß eine rasterelektronische Aufnahme einer Meßstruktur gemacht, die Teile mit unterschiedlichen Rückstreueigenschaften aufweist, und diese Aufnahme wird dann ausgewertet. Aus Verzerrungen in dem Bild kann, insbesondere auch unter Zuhilfenahme eines Rechners, auf die Güte der Magnetoptiken von Fokussiereinheit und Optik zurückgeschlossen werden.

Verwendet wird hierzu vorzugsweise eine etwas andere Meßstruktur, die eine regelmäßige Struktur, insbesondere ein Gitter oder Netz umfaßt, damit übliche aus der Optik bekannte Rechenverfahren zur Berechnung der Verzerrung eingesetzt werden können. Bei einer bevorzugten Ausführungsform bestehen die Gitter- oder Netzlinien aus einem stark rückstreuenden Material, insbesondere einem Metall, während ihr Untergrund aus einem nicht oder nur schwach rückstreuenden Material gebildet ist, beispielsweise Graphit.

Auch eine Meßstruktur mit regelmäßig angeordneten Stellen erhöhter Durchlässigkeit (z. B. Bohrungen) oder mit regelmäßig angeordneten Stellen erhöhter Rückstreuung (z.B. Rückstreuflächen) oder mit einem Gitter oder Netz sind Gegenstand der vorliegenden Erfindung, wobei bevorzugte Ausführungsformen die o.g. Materialeigenschaften aufweisen.

Denkbar ist auch, daß eine Nadel oder mehrere Nadeln mit geschliffener Endfläche oder andere Rückstreuelemente, die beim Verfahren zum Vermessen des Intensitätsprofils eingesetzt wird/werden, in eine Meßstruktur mit Gitternetz vorzugsweise lösbar eingesetzt sind, um sowohl Intensitätsprofile des Strahles als auch Abbildungseigenschaften der Optik messen zu können.

Alternativ kann man eine Rückstreuflächenanordnung und eine rückstreuende Gitteranordnung auch auf seitlich benachbarten Bereichen der Oberseite der Basis einer Meßstruktur vorsehen, so daß dies Bereiche wahlweise auf die Hauptstrahlachse gestellt werden können.

Nachfolgend werden bevorzugte Ausführungsformen der Erfindung unter Bezug auf die Zeichnung beschrieben. Dort zeigen:
- Figur 1:: schematisch den Aufbau zum Vermessen des Intensitätsprofils eines Elektronenstrahls eines Elektronenstrahlschweißgeräts;
- Figur 2:: schematisch den Aufbau zum Messen der Abbildungseigenschaften von Magnetoptiken in einem Elektronenstrahlschweißgerät;
- Figur 3:: eine Aufsicht auf eine abgewandelte Meßstruktur mit ein Gitter bildenden schmalen Rückstreubändern;
- Figur 4:: einen transversalen Schnitt durch die Meßstruktur nach Figur 3 längs der dortigen Schnittlinie IV-IV;
- Figur 5:: einen vergrößerten transversalen Schnitt durch ein Rückstreuband der Meßstruktur nach Figur 3;
- Figur 6:: einen transversalen Mittenschnitt durch eine abgewandelte Meßstruktur;
- Figur 7:: einen transversalen Mittelschnitt durch eine nochmals abgewandelte Meßstruktur; und
- Figur 8:: eine Aufsicht auf eine weiter abgewandelte Meßstruktur.

In einem Elektronenstrahlschweißgerät wird ein Elektronenstrahl 10 von einer als einzelne Linse 12 gezeigten steuerbaren Fokussiereinheit fokussiert. Diese kann insbesondere einen Stigmator (zwei unter 90° angeordnete Zylinderlinsen) umfassen, die getrennt steuerbar sind, um die Form des Strahlquerschnittes zu modifizieren, insbesondere auf Kreisform zu bringen.

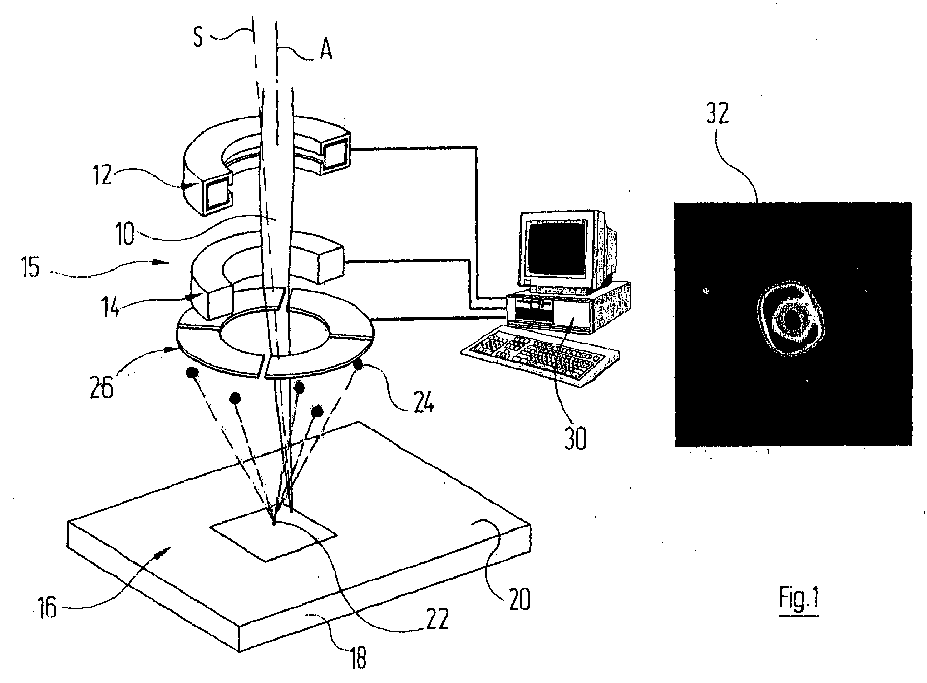

In Figur 1 ist bei A die Hauptstrahlrichtung angedeutet, das ist die Richtung, in welcher der Elektronenstrahl 10 von der nicht im einzelnen dargestellten Elektronenkanone des Schweißgerätes erzeugt wird und in welcher er auf ein Werkstück (nicht dargestellt) unter Arbeitsbedingungen auftrifft, wenn er nicht abgelenkt wird.

Der Elektronenstrahl 10 kann mittels einer magnetischen Ablenkeinheit 14, die hinter der Linse 12 liegt, senkrecht zur Strahlrichtung abgelenkt werden. Die Ablenkeinheit 14 umfaßt mindestens zwei getrennt steuerbare Spulen (nicht im einzelnen gezeigt) zur Ablenkung des Elektronenstrahles 10 in zwei zu einander senkrechten Richtungen.

Die Fokussiereinheit 12 und die Optik 14 bilden zusammen eine Optik 15 des Elektronenstrahlschweißgerätes.

Zum Vermessen des Intensitätsprofils des Elektronenstrahls 10 ist eine im ganzen mit 16 bezeichnete Meßstruktur vorgesehen. Diese besteht aus einer als Graphitplatte 18 ausgebildeten Basis mit einer ebenen Oberflächen 20, von der im Zentralbereich, d.h. in dem Bereich, auf den der Elektronenstrahl 10 auftrifft, wenn er von der Ablenkeinheit 14 nicht stark ausgelenkt wird, senkrecht nach oben eine Wolframnadel 22 absteht.

Die Wolframnadel 22 ist an ihrer zur Elektronenstrahlquelle weisenden, senkrecht auf der Hauptstrahlrichtung A stehenden ebenen Endfläche glatt geschliffen. Auch die Oberfläche 20 der Graphitplatte 18 steht senkrecht auf der Haupstrahlrichtung A.

Der Durchmesser der Wolframnadel 22 ist so bemessen, daß er deutlich kleiner als der Durchmesser des Elektronenstrahls 10 ist.

Die Wahl der Materialien für die Meßstruktur 16 und ihre Geometrie und Anordnung bewirken folgendes:

Die glattgeschliffene transversale Endfläche der Wolframnadel 22 wirkt stark rückstreuend, d.h. Elektronen aus dem Elektronenstrahl 10 werden in die Richtung A, aus der der Elektronenstrahl 10 kommt bzw. in eine Richtung mit einer Komponente in die Richtung der Elektronenquelle, zurückgelenkt. Rückstreuelektronen von der Nadel 22, die erhalten werden, wenn der Elektronenstrahl 10 die Spitze der Nadel 22 überstreicht, sind in Figur 1 schematisch bei 24 andeutet. Die Graphitplatte 18 hingegen wirkt kaum rückstreuend, so daß sich die Wolframnadel 22 gegen die Oberfläche 20 stark abhebt.

Die Rückstreuelektronen werden mittels eines Sensorrings, der im ganzen mit 26 bezeichnet ist und aus vier Sensorsegmenten 28 besteht, vermessen, wobei der Sensorring 26 den Pfad des Elektronenstrahls im Querschnitt gesehen umgibt, wobei der Sensorring ein herkömmlicher Ring der Art ist, wie er üblicherweise in rasterelektronischen Beobachtungseinrichtungen zum Auffangen von Rückstreuelektronen verwendet wird. Aus diesem Grund kann der Sensorring 26 sowohl zur Messung des Stromes der Rückstreuelektronen als auch zur Bildgebung verwendet werden.

Bei der Erfindung geht es zunächst darum, die Stärke des Rückstreuelektronenstroms zu bestimmen, wobei es nicht in erster Linie um die absolute Zahl der Rückstreuelektronen geht, die ja von dem Sensorring gar nicht alle erfaßt werden, sondern um das relative Intensitätsprofil des Elektronenstrahls 10, also die Verteilung der Elektronen im Elektronenstrahl 10 in zur Strahlrichtung senkrechter Richtung.

Unter Strahlrichtung S soll die mittlere Richtung des Elektronenstrahles verstanden werden, wie sie von der Optik 14 erzeugt wird, abgesehen von Auslenkungen kleiner Amplitude, die erfolgen, um den Elektronenstrahl 10 über der Endfläche einer Wolframnadel 22 zu rastern.

Wird der Elektronenstrahl 10 von der Ablenkeinheit 14 auf verschiedene Stellen der Meßstruktur 16 geleitet, so erhöht und erniedrigt sich die Zahl der Rückstreuelektronen 24 je nach der Stelle auf der Meßstruktur 16, auf die der Elektronenstrahl 10 auftrifft. Eine besonders hohe Zahl von Rückstreuelektronen wird erzielt, wenn der Elektronenstrahl 10 auf die Wolframnadel 22 trifft.

Da der Elektronenstrahl 10 in seinem Durchmesser in der Ebene der Meßstruktur 16 bzw. der Oberfläche 20 größer ist als die Wolframnadel 22, treffen beim Überstreichen der Wolframnadel 22 durch den Elektronenstrahl 10 verschiedene Elektronenstrahlteile auf die Wolframnadel auf, und eine unterschiedliche Intensität des Strahls in diesen Teilen führt zu einer unterschiedlichen Zahl von Rückstreuelektronen.

Um das Strahlprofil systematisch zu erfassen (bzw. bei Arbeitsbedingungen des Elektronenstrahl über die Werkstückoberfläche zu führen), wird die Optik 15 von einer Rechen-, Steuer- und Speichereinheit 30 elektronisch gesteuert, und Signale von dem Sensorring werden der Rechen-, Steuer- und Speichereinheit 30 zugeführt und in Abhängigkeit von den Ablenk-Steuersignalen erfaßt. Dabei sind die Fokussiereeinheit 12 und die Ablenkeinheit 14 getrennt steuerbar.

Dies bedeutet im Meßmodus, daß in Abhängigkeit von einer Größe x (der Auslenkung in x-Richtung; vgl. das Koordinatensystem in Figur 1) und einer Größe y (der Auslenkung in y-Richtung) des Elektronenstrahls 10, welche durch die Optik 15 erzeugt wird, der Strom der Rückstreuelektronen 24, die zum Sensorring 26 gelangen, erfaßt wird, wobei diese Daten als dreidimensionale Flächen (nicht gezeigt) ausgegeben werden können, oder auch in Form eines Bildes 32, das die Elektronendichte an einer bestimmten Stelle z des Elektronenstrahles in einer zur Strahlrichtung S bzw. zur Hauptstrahlrichtung A senkrechten Richtung wiedergibt.

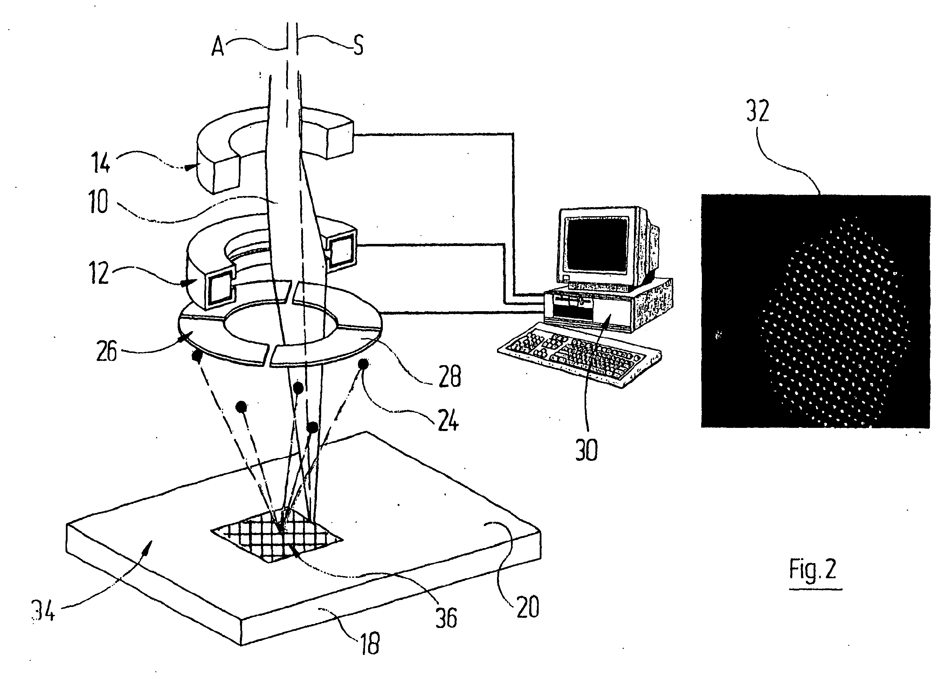

Mit einer anderen Meßstruktur, die in Figur 2 gezeigt ist und dort im ganzen mit 34 bezeichnet ist, läßt sich unter Verwendung im wesentlichen desselben Aufbaus die Güte der Linse 12 und der Ablenkeinheit 14 vermessen, was eine wichtige Information zur Beurteilung der Qualität des Elektronenstrahlschweißgeräts darstellt.

Die Meßstruktur 34 umfaßt auch hier eine Graphitplatte 18 mit einer Oberfläche 20. Im Zentralbereich der Graphitplatte 18 befindet sich auf der Oberfläche 20 jedoch ein Metallnetz 36, d.h. ein Netz, dessen Netzlinien aus Metall bestehen. Das Netz kann direkt auf dem Graphit 18 aufliegen, so daß auch hier Rückstreuelektronen 24 von den Linien des Netzes ausgesandt werden, während der Graphithintergrund nicht rückstreuend wirkt.

Ein Unterschied zu Figur 1 besteht auch insofern, als zur besseren Abbildung des Netzes 36 der Ort von Linse 12 und Ablenkeinheit 14 vertauscht sind.

Unter Verwendung eines üblichen rasterelektronenmikroskopischen Bilderzeugungsverfahrens kann mittels des Sensorrings 26 ein Bild 38 des Metallnetzes 36 vor dem Graphituntergrund erzeugt werden. Mittels der dem Fachmann geläufigen Computerauswertung des Bildes 38 kann aufgrund von Abweichungen der einzelnen Linien von deren geradem Verlauf und den Verzerrungen am Rand des abgebildeten Netzes auf die Güte der Magnetoptiken der Ablenkeinheit 14 rückgeschlossen werden.

Die Meßstruktur 34 kann - in Abwandlung - Teil der Meßstruktur 16 aus Figur 1 sein, wobei dann die Wolframnadel 22 in einer kleinen Graphitplatte in die große Graphitplatte 18 eingesetzt wird, und wenn sie dann entfernt wird, ist das Metallnetz 36 in der Graphitplatte 18 dann freigegeben.

Möglicherweise muß dann die Linse 12 nachfokussiert werden, damit das Netz scharf abgebildet wird, während sie vorher auf die Oberfläche 20, aus der die Wolframnadel 22 herausstand, fokussiert war. Alternativ kann man die Entfernungsdifferenz auch durch eine aus Graphit gefertigte Distanzplatte aufnehmen.

Nochmals alternativ kann man ein Nadelanordnung und eine Gitteranordnung auch nebeneinander liegend auf einer gemeinsamen Basis-Graphitplatte vorsehen und die beiden Teilbereiche der Graphitplatte alternativ in den Strahlengang stellen, z.B. mit einer kalibrierten Gewindespindel oder mit einem kleinen Arbeitszylinder und die Plattenendlagen vorgebenden Anschlägen.

Die Meßstrukturen 16 und 34 bzw. die oben angesprochenen kombinierten Meßstrukturen sind so ausgelegt, daß sie leicht und präzise in das Elektronenstrahlschweißgerät eingesetzt werden können und auch leicht wieder entnommen werden können (z.B. unter Verwendung von Paßstiften), damit das Elektronenstrahlschweißgerät seine eigentliche Funktion ausüben kann. Es genügt hierfür, wenn in einer Abbildungsebene die Möglichkeit zur genau positionierten Anbringung der Graphitplatte 18 besteht.

Da die Meßstrukturen 16 und 34 passive Komponenten sind, müssen keine zusätzlichen Leitungen in den Meßraum/Arbeitsraum des Elektronenstrahlschweißgerätes verlegt werden, um den Strahlquerschnitt und die abbildungseigenschaften der Optik 15 zu bestimmen.

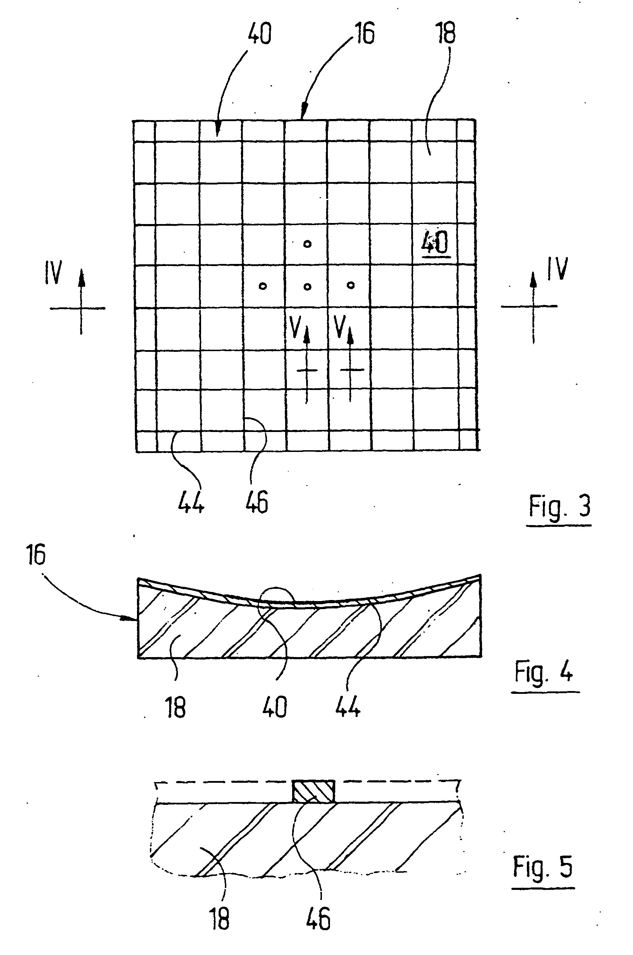

Figur 3 zeigt in Aufsicht eine Meßstruktur 16, die wieder eine Basis 20 aus Graphit aufweist. Die obere Begrenzungsfläche der Basis 20 ist konkav kugelförmig gewölbt, wobei der Radius der oberen Stirnfläche 40 dem Abstand der Basis 20 vom Hauptpunkt H der Strahl-Ablenkeinheit 14 des Elektronenstrahl-Schweißgerätes entspricht. Unter dem "Hauptpunkt" soll derjenige Punkt verstanden werden, an dem der Elektronenstrahl bei idealisierter Darstellung von der Einfallsrichtung abknickt (ähnlich wie bei optischen Linsen).

Auf die Stirnfläche 40 ist ein Netz 42 aufgebracht, welches aus unter rechtem Winkel zueinander angeordneten Sätzen von Rückstreubändern 44, 46 besteht. Die Rückstreubänder 44, 46 sind wieder aus einem Metall hoher Dichte wie z.B. Wolfram hergestellt und können auf eine beliebige bekannte Weise hergestellt sein, z.B. durch Herausschneiden aus einem dünnen polierten Blech mit einem Laserstrahl oder durch Aufkleben von entsprechend schmalen polierten Bändern im gewünschten Muster auf die Stirnfläche 40.

Wie aus Figur 5 ersichtlich, ist der Querschnitt der Rückstreubänder 46 rechteckig, so daß deren freie Oberseiten jeweils eine Rückstreufläche 48 bilden.

Um mit einer solchen Meßstruktur auch das Intensitätsprofil für verschieden Strahlauslenkungen messen zu können, kann man in der Mitte ausgesuchter oder aller der Gitterzellen jeweils eine vorzugsweise sehr kurze Wolframnadel 22 mit im wesentlichen in der Fläche der benachbarten Rückstreubänder 44, 46 liegender Endfläche vorsehen. Dadurch, daß man den Elektronenstrahl mit kleiner Amplitude über den verschiedenen Wolframnadeln 22 aufrastert, kann man dann die Intensitätsprofile des Elektronenstrahles 10 für unterschiedliche Auslenkwinkel messen, durch Auslenkung des Elektronenstrhles über die Gitterlinien hinweg die Abblidungseigenschaften der durch Fokussiereinheit 12 und Ablenkeinheit 14 gebildeten Optik 15.

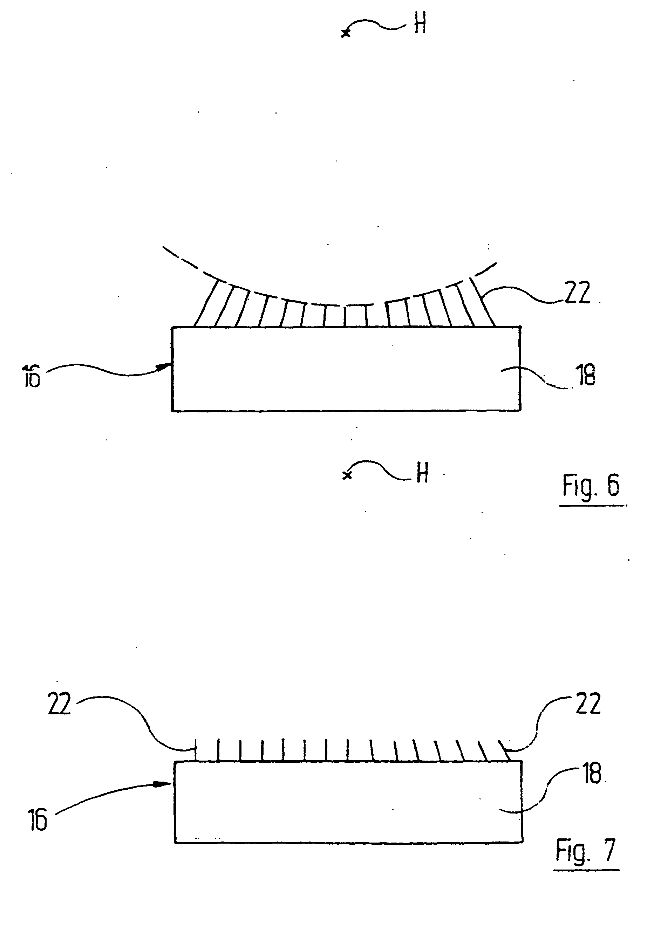

Figur 6 zeigt einen Mittenschnitt durch eine weiter abgewandelte Meßstruktur 16, bei welcher die Basis 20 einzelne Wolframnadeln 22 trägt, die jeweils so schräg gestellt sind, daß ihre Achse durch den Hauptpunkt H der Elektronenstrahl-Ablenkeinheit verläuft. Die Meßstruktur 16 nach Figur 6 hat somit eine Vielzahl von kleinen Rückstreuflächen, die jeweils senkrecht auf der Richtung eines ausgelenkten Elektronenstrahles stehen und gleichen Abstand vom Hauptpunkt H aufweisen.

Die Wolframnadeln 22 sind entweder so angeordnet, daß ihre Fußabschnitte auf der Oberseite der Basis 20 ein quadratisches Gitter bilden, oder auch so, daß jeweils ein Satz von Wolframnadeln 22 unter gleichem Abstand von der Achse der Elektronenkanone angeordnet sind und die zu diesem Satz gehörenden Wolframnadeln 22 in Umfangsrichtung unter äquidistantem Winkelabstand angeordnet sind.

Die weiter abgewandelte Meßstruktur nach Figur 7 ähnelt im rechten Teil derjenigen nach Figur 6 mit der Maßgabe, daß die Enden der Wolframnadeln 22 alle in derselben Ebene liegen und vorzugsweise dort so angeordnet sind, daß die Endflächen ein quadratisches Gitter bilden.

In der linken Hälfte von Figur 7 stehen die Wolframnadeln 22 alle senkrecht auf der Oberfläche der Basis 20. Eine solche Anordnung der Wolframnadeln 22 kann zuweilen dann von Interesse sein, wenn man nicht an der Intensitätsverteilung der Elektronen im Elektronenstrahl an sich (senkerecht zur Strahlrichtung S) interessiert ist sondern nur an der Elektronenverteilung, soweit sie für das Schweißen relevant ist (oder auch dann, wenn der Ablenkradius groß gegen die Auslenkstrecke ist). Da beim Schweiβen die Werkstückoberfläche in der Regel senkrecht auf der Hauptstrahlrichtung A der Elektronenkanone steht, bilden die vielen rückstreuenden Endflächen der Wolframnadeln 22 gemäß der linken Hälfte von Figur 7 die Werkstückoberfläche an einer Vielzahl von Stützstellen nach.

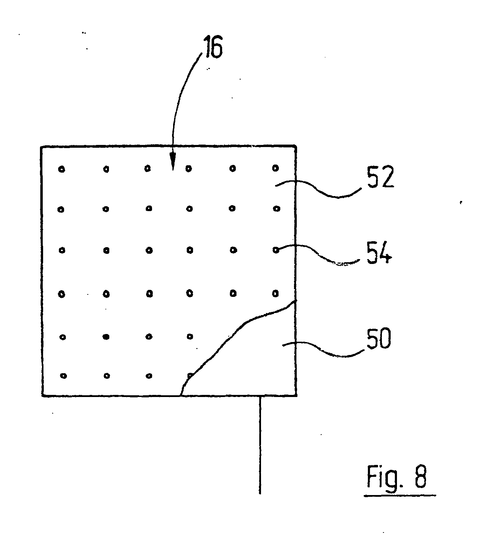

Das Ausführungsbeispiel nach Figur 8 zeigt eine Meßanordnung zum Messen von Strahlquerschnitt und Abbildungseigenschaften, die eine Meßstruktur 16 und eine hinter dieser liegende elektrisch leitende Kollektorplatte 50 umfaßt. Die Meßstruktur 16 besteht aus einer Platte 52 aus Wolfram, in die in regelmäßigem Raster kleinen Durchmesser aufweisende Bohrungen 54 eingearbeitet sind, z.B. durch Elektronenstrahlbohren.

Diese Anordnung arbeitet in Transmission und misst den Strom der von der mit einem Strommesser (nicht gezeigt) verbundenen Kollektorplatte 50 aufgefangenen Elektronen in Abhängigkeit von der Auslenkung (und ggf. der Fokussierung) des Elektronenstrahles.

## Patentansprüche

1. Verfahren zum Vermessen des Intensitätsprofils eines Elektronenstrahls (10) insbesondere eines Strahls eines Elektronenstrahlbearbeitungsgeräts und/oder zum Vermessen einer Optik (15) für einen Elektronenstrahl und/oder zum Justieren einer Optik (15) für einen Elektronenstrahl bei dem der Elektronenstrahl durch eine Relativbewegung zwischen Elektronenstrahl und einer Meßstruktur (16) auf verschiedene Stellen (22, 20) von dieser geleitet wird, die unterschiedliche Rückstreueigenschaften aufweisen, wobei ein Strom von der Meßstruktur (16) in Rückwärtsrichtung gestreuter Elektronen in Abhängigkeit von der Relativbewegung von Elektronenstrahl (10) und Meßstruktur (16) gemessen, wird **dadurch gekennzeichnet, daß** eine Meßstruktur, verwendet wird, die mindestens eine kreisförmige Öffnung oder eine kreisförmige Rückstreufläche, welche den Elektronenstrahl zumindest teilweise zurückwirft, aufweist, deren Querschnittsabmessung kleiner ist als der Elektronenstrahldurchmesser.

2. verfahren nach Anspruch 1, **dadurch gekennzeichnet, daß** die Rückstreufläche senkrecht auf der mittleren Richtung des Elektronenstrahles steht.

3. Verfahren nach Anspruch 2, **dadurch gekennzeichnet, daß** die Rückstreufläche von einer Erhebung (22) getragen ist.

4. Verfahren nach Anspruch 3, **dadurch gekennzeichnet, daß** die Erhebung von einer Nadel (22) vorzugsweise einer Metallnadel, insbesondere aus einem schweren Metall wie Wolfram gebildet wird.

5. Verfahren nach Anspruch 4, **dadurch gekennzeichnet, daß**, die Nadel (22) an ihrem Ende geschliffen ist.

6. Verfahren nach Anspruch 4 oder 5, **dadurch gekennzeichnet, daß** die Achse der Nadel (22) parallel zur mittleren Richtung des Elektronenstrahles verläuft.

7. Verfahren nach einem der vorhergehenden Ansprüche **dadurch gekennzeichnet, daß** der Strom der Rückstreuelektronen (20) mittels eines Sensorringes (26) gemessen wird, der vorzugsweise eine Mehrzahl um die Achse des Elektronenstrahles (10) verteilter, vorzugsweise äquidistant verteilter, Sensorsegmente (28) umfasst.

8. Verfahren nach einem der vorhergehenden Ansprüche, **dadurch gekennzeichnet, daß** die Relativbewegung durch Ablenken des Elektronenstrahls mittels eines Magnetfeldes (14) oder elektrischen Feldes erzeugt wird.

9. Verfahren nach einem der Ansprüche 1 bis 8, **dadurch gekennzeichnet, daß** eine Meßstruktur (16) verwendet wird, die eine Mehrzahl von kreisförmigen Öffnungen und/oder kreisförmigen Rückstreuflächen aufweist, die unter unterschiedlichem Abstand von der Einfallsrichtung des nicht ausgelenkten Elektronenstrahles angeordnet sind.

10. Verfahren nach Anspruch 9, **dadurch gekennzeichnet, daß** eine Meßstruktur (16) verwendet wird, bei welcher die Öffnungen und/oder die Rückstreuflächen gleichförmig in radialer Richtung und/oder Umfangsrichtung verteilt angeordnet sind.

11. Verfahren nach Anspruch 10, **dadurch gekennzeichnet, daß** eine Meßstruktur (16) verwendet wird, bei welcher die Öffnungen und/oder die Rückstreuflächen so ausgerichtet sind, dass ihre Achse bzw. Normale durch den Hauptpunkt der Optik (15) verläuft.

12. Verfahren nach einem der Ansprüche 1 bis 11, **dadurch gekennzeichnet, daß** die Relativbewegung zwischen Elektronenstrahl und Meßstruktur in zwei unabhängigen Richtungen erfolgt, die im Wesentlichen in einer senkrecht zur Einfallsrichtung des nicht abgelenkten Elektronenstrahls (10) liegenden Ebene liegen.

13. Verfahren nach einem der Ansprüche 1 bis 12, **dadurch gekennzeichnet, daß** eine Meßstruktur, (16) verwendet wird, die in der Nachbarschaft der Rückstreuflächen eine ebene Oberfläche (20) aus schwach oder gar nicht rückstreuendem Material aufweist, die insbesondere aus Graphit besteht.

14. Verfahren nach einem der Ansprüche 1 bis 13 zur Vermessung der Elektronenstrahl-Optik, **dadurch gegekennzeichnet, daß** an einer Mehrzahl von kreisförmigen Öffnungen und/oder Rückstreuflächen die unterschiedliche Lage bezüglich der Einfallsrichtung des nicht abgelenkten Elektronenstrahles aufweisen, der Strahlquerschnitt des Elektronenstrahles vermessen wird und mit einem Strahlquerschnitt eines Elektronenstrahles verglichen wird, wie er bei fehlerfreier Elektronenstrahl-Optik erhalten wird und/oder die Abbildungseigenschaften der Optik (15) gemessen werden.

15. Verfahren nach Anspruch 14, **dadurch gekennzeichnet, daß** die Meßstruktur als Gitter ausgebildet wird, dass durch die Relativbewegung zwischen Elektronenstrahl und Meßstruktur (16) zumindest ein erheblicher Teil des Gitters vom Elektronenstrahl getroffen wird und der Strom der rückgestreuten Elektronen in Abhängigkeit von der Relativbewegung in ein Bild der Meßsttruktur umgesetzt wird und dieses Bild mit einem Sollbild der Meßstruktur verglichen wird, wie es bei fehlerfreier Elektronenstrahl-Optik erhalten wird.

16. Verfahren zum Kompensieren von Ablenkungsfehlern einer Elektronenstrahl-Optik, bei welchem die Abbildungseigenschaften der Elektronenstrahl-Optik (15) mit dem Verfahren gemäß Anspruch 14 oder 15 ermittelt werden und zumindest eine steuerbare Komponente der Optik so nachgeregelt wird, daß der Unterschied zwischen Ist-Bild und Soll-Bild der Meßstruktur minimiert wird.

17. Meßstruktur zum Vermessen des Intensitätsprofils eines Elektronenstrahls (10), insbesondere eines Strahls eines Elektronenstrahlbearbeitungsgeräts, und/oder zum Vermessen einer Optik (15) für einen Elektronenstrahl und/oder zum Justieren einer Optik (15) für einen Elektronenstrahl, **gekennzeichnet, daß** sie eine Basis aufweist, die mindestens eine kreisförmige Öffnung und/oder eine kreisförmige Rückstreufläche aufweist, deren Querschnittsabmessung kleiner ist als der Elektronenstrahldurchmesser.

18. Meßstruktur nach Anspruch 17, **dadurch gekennzeichnet, daß** die Achsen der Öffnungen und/oder die Normale der Rückstreiflächen durch einen Hauptpunkt der Optik verlaufen.

19. Meßstruktur nach Anspruch 17 oder 18, **dadurch gekennzeichnet, daß** die Rückstreuflächen durch Endflächen von Nadeln (22) gebildet sind, die vorzugsweise aus Metall, insbesondere aus einem schweren Metall wie Wolfram, gefertigt sind und von der Basis getragen sind.

20. Meßstruktur nach Anspruch 19, bei der die Nadel (22) an ihrem freien Ende glatt geschlitten ist, vorzugsweise im wesentlichen parallel zur ebenen Oberfläche (20) der Basis.

21. Meßstruktur nach einem der Ansprüche 17 bis 20, **dadurch gekennzeichnet, daß** die ebene Oberfläche (20) der Basis aus schwach oder gar nicht rückstreuendem Material, insbesondere aus Graphit, gebildet ist.

22. Meßstruktur nach einem der Ansprüche 22 bis 26, **dadurch gekennzeichnet, daß** sie rückstreuende Bänder (46) aufweist, die ein Gitter bilden, und in den durch die Kanten der Gittermaschen begrenzten Flächen zusätzlich jeweils mindestens eine Rückstreufläche (22) aufweist.

23. Meßstruktur, nach einem der Ansprüche 17 bis 22, daß die Rückstreuflächen (22) jeweils bei der Mitte von durch die Gitterlinien begrenzten Flächen liegen.

24. Meßstruktur nach einem der Ansprüche 17 bis 23, **gekennzeichnet durch** eine in Strahlrichtung gesehen hinter ihr liegende Kollektorplatte (50).

25. Elektronenstrahlbearbeitungsgerät, mit:
- einer Meßstruktur nach einem der Ansprüche 17 bis 23, und
- einem im Elektronenstrahlgang vor der Meßstruktur angeordneten Rückstreuelektronenmeßgerät (26).

26. Elektronenstrahlbearbeitungsgerät nach Anspruch 25, **dadurch gekennzeichnet, daß** das Rückstreuelektronenmeßgerät einen Sensorring (26) umfaßt, der vorzugsweise eine Mehrzahl in Umfangsrichtung verteilter, vorzugsweise gleich verteilter Sensorsegmente (28) aufweist.

27. Elektronenstrahlbearbeitungsgerät nach Anspruch 25 oder 26, **gekennzeichnet durch** eine Optik (15), die mittels Steuersignalen einer Steuereinheit (30) elektronisch gesteuert wird, wobei eine Speichereinheit (30) gleichzeitig Signale von dem Rückstreuelektronenmeßgerät (26) in Abhängigkeit von den Steuersignalen erfaßt.

28. Elektronenstrahlbearbeitungsgerät nach Anspruch 27, **dadurch gekennzeichnet, daß** die Optik (15) mit der Steuereinheit (30) sowie das Rückstreuelektronenmeßgerät (26) zum Erzeugen eines rasterelektronenmikroskopischen Bildes ausgelegt sind.

29. Elektronenstrahlbearbeitungsgerät nach Anspruch 26, **dadurch gekennzeichnet, daß** bei einer im wesentlichen punktförmigen Rückstreufläche (22) der Meßstruktur (16) in einer Elektronenstrahl-Optik (15) eine Fokussierlinse (12) in Strahlrichtung gesehen vor einer Strahl-Ablenkeinheit (14) steht.

30. Elektronenstrahlbearbeitungsgerät nach Anspruch 26, **dadurch gekennzeichnet, daß** bei einer ausgedehnten Rückstreufläche (32) der Meßstruktur (16) in einer Elektronenstrahl-Optik (15) eine Fokussierlinse (12) in Strahlrichtung gesehen hinter einer Strahl-Ablenkeinheit (14) steht.

## Claims

1. A method for measuring the intensity profile of an electron beam (10), in particular a beam of an electron-beam machining device, and/or for measuring an optical system (15) for an electron beam, and/or for adjusting an optical system (15) for an electron beam, in which the electron beam is directed by relative movement between the electron beam and a measuring structure (16) onto different points (22, 20) of the latter which have different back-scattering properties, a stream of electrons scattered in the reverse direction by the measuring structure (16) being measured as a function of the relative movement of the electron beam (10) and the measuring structure (16),
is **characterised in that** a measuring structure which has at least one circular opening or a circular back-scattering surface, which reflects the electron beam at least partially, and the cross-section measurement of which is smaller than the electron beam diameter, is used.

2. Method according to Claim 1, **characterised in that** the back-scattering surface is disposed perpendicularly to the mean direction of the electron beam.

3. Method according to Claim 2, **characterised in that** the back-scattering surface is carried by a raised element (22).

4. Method according to Claim 3, **characterised in that** the raised element is formed by a needle (22), preferably a metal needle, in particular of a heavy metal such as tungsten.

5. Method according to Claim 4, **characterised in that** the needle (22) is ground at its end.

6. Method according to Claim 4 or 5, **characterised in that** the axis of the needle (22) runs parallel to the mean direction of the electron beam.

7. Method according to any one of the preceding claims, **characterised in that** the stream of back-scattered electrons (20) is measured by means of a sensor ring (26), which preferably includes a plurality of sensor segments (28) distributed, preferably equidistantly, around the axis of the electron beam (10).

8. Method according to any one of the preceding claims, **characterised in that** the relative movement is generated by deflecting the electron beam by means of a magnetic field (14) or an electrical field.

9. Method according to any one of Claims 1 to 8, **characterised in that** a measuring structure (16) is used which includes a plurality of circular openings and/or circular back-scattering surfaces which are arranged at different distances from the incidence direction of the undeflected electron beam.

10. Method according to Claim 9, **characterised in that** a measuring structure (16) is used in which the openings and/or back-scattering surfaces are distributed uniformly in the radial and/or circumferential direction.

11. Method according to Claim 10, **characterised in that** a measuring structure (16) is used in which the openings and/or back-scattering surfaces are so aligned that their axes or normals pass through the principal point of the optical system (15).

12. Method according to any one of Claims 1 to 11, **characterised in that** the relative movement between the electron beam and the measuring structure takes place in two independent directions which lie substantially in a plane disposed perpendicularly to the incidence direction of the undeflected electron beam (10).

13. Method according to any one of Claims 1 to 12, **characterised in that** a measuring structure (16) is used which has adjacently to the back-scattering surfaces a flat surface (20) of a material, in particular graphite, which back-scatters weakly or not at all.

14. Method according to any one of Claims 1 to 13 for measuring the optical system for an electron beam, **characterised in that** the beam cross-section of the electron beam is measured at a plurality of circular openings and/or back-scattering surfaces which have different positions relative to the incidence direction of the undeflected electron beam, and is compared with a beam cross-section of an electron beam as obtained by means of a correctly functioning optical system for an electron beam, and/or the imaging properties of the optical system (15) are measured.

15. Method according to Claim 14, **characterised in that** the measuring structure is in the form of a grid, **in that** at least a considerable portion of the grid is impinged upon by the electron beam through the relative movement between the electron beam and the measuring structure (16), the stream of back-scattered electrons as a function of the relative movement is converted into an image of the measuring structure, and this image is compared with a reference image of the measuring structure as obtained by means of a correctly functioning optical system for an electron beam.

16. A method for compensating for deflection errors of an optical system for an electron beam, wherein the imaging properties of the optical system (15) for the electron beam are determined using the method according to Claim 14 or 15, and at least one controllable component of the optical system is so adjusted that the difference between the actual image and the reference image of the measuring structure is minimised.

17. A measuring structure for measuring the intensity profile of an electron beam (10), in particular a beam of an electron-beam machining device, and/or for measuring an optical system (15) for an electron beam, and/or for adjusting an optical system (15) for an electron beam, **characterized in that** it has a base which has at least one circular opening and/or one circular back-scattering surface, the cross-section dimension of which is less than the electron beam diameter.

18. Measuring structure according to Claim 17, **characterised in that** the axes of the openings and/or the normals of the back-scattering surfaces run through a principal point of the optical system.

19. Measuring structure according to Claim 17 or 18, **characterised in that** the back-scattering surfaces are formed by end faces of needles (22) which are made preferably of metal, in particular of a heavy metal such as tungsten, and are carried by the base.

20. Measuring structure according to Claim 19, wherein the needle (22) is ground smooth at its free end, preferably substantially parallel to the flat surface (20) of the base.

21. Measuring structure according to any one of Claims 17 to 20, **characterised in that** the flat surface (20) of the base is formed of a material, in particular graphite, which back-scatters weakly or not at all.

22. Measuring structure according to any one of Claims 22 to 26, **characterised in that** it includes back-scattering strips (46) forming a grid, and additionally includes at least one back-scattering surface (22) in each of the areas delimited by the grid meshes.

23. Measuring structure according to any one of Claims 17 to 22, **characterised in that** the back-scattering surfaces (22) are located in each case at the centres of the areas delimited by the gridlines.

24. Measuring structure according to any one of Claims 17 to 23, **characterised by** a collector plate (50) located downstream of said measuring structure, viewed in the direction of the beam.

25. An electron-beam machining device, comprising:
- a measuring structure according to any one of Claims 17 to 23, and
- a back-scattered electrons measuring device (26) arranged in the electron beam path upstream of the measuring structure.

26. Electron-beam machining device according to Claim 25, **characterised in that** the back-scattered electrons measuring device includes a sensor ring (26), which preferably includes a plurality of sensor segments (28) distributed, preferably uniformly, in the circumferential direction.

27. Electron-beam machining device according to Claim 25 or 26, **characterised by** an optical system (15) which is electronically controlled by means of control signals of a control unit (30), a memory unit (30) at the same time detecting signals from the back-scattered electrons measuring device (26) as a function of the control signals.

28. Electron-beam machining device according to Claim 27, **characterised in that** the optical system (15), together with the control unit (30) and the back-scattered electrons measuring device (26), are designed to generate an image produced by scanning electron microscopy.

29. Electron-beam machining device according to Claim 26, **characterised in that**, in the case of a measuring structure (16) which has a substantially punctual back-scattering surface (22), in an optical system (15) for an electron beam, a focusing lens (12) is located upstream of a beam deflector unit (14), viewed in the direction of the beam.

30. Electron-beam machining device according to Claim 26, **characterised in that**, in the case of a measuring structure (16) which has an extensive back-scattering surface (32), in an optical system (15) for an electron beam, a focusing lens (12) is located downstream of a beam deflector unit (14), viewed in the direction of the beam.

## Revendications

1. Procédé de mesure du profil d'intensité d'un faisceau d'électrons (10), en particulier d'un faisceau d'un appareil d'usinage par faisceau d'électrons, et/ou de mesure d'une optique (15) pour un faisceau d'électrons et/ou d'ajustement d'une optique (15) pour un faisceau d'électrons, dans lequel le faisceau d'électrons est dirigé, par un mouvement relatif entre faisceau d'électrons et une structure de mesure (16), sur différents points (22, 20) de celle-ci qui présentent des caractéristiques de rétrodiffusion différentes, un courant d'électrons diffusés en sens rétrograde par la structure de mesure (16) étant mesuré en fonction du mouvement relatif entre faisceau d'électrons (10) et structure de mesure (16), **caractérisé en ce que** l'on utilise une structure de mesure (16) qui présente au moins une ouverture circulaire ou une surface de rétrodiffusion circulaire qui réfléchit le faisceau d'électrons au moins partiellement, dont la section est inférieure au diamètre du faisceau d'électrons.

2. Procédé selon la revendication 1, **caractérisé en ce que** la surface de rétrodiffusion est perpendiculaire à la direction moyenne du faisceau d'électrons.

3. Procédé selon la revendication 2, **caractérisé en ce que** la surface de rétrodiffusion est portée par une élévation (22).

4. Procédé selon la revendication 3, **caractérisé en ce que** l'élévation est formée par une aiguille (22), de préférence une aiguille métallique, en particulier en métal lourd comme du tungstène.

5. Procédé selon la revendication 4, **caractérisé en ce que** l'aiguille (22) est meulée à son extrémité.

6. Procédé selon la revendication 4 ou 5, **caractérisé en ce que** l'axe de l'aiguille (22) est parallèle à la direction moyenne du faisceau d'électrons.

7. Procédé selon une des revendications précédentes, **caractérisé en ce que** le courant des électrons rétrodiffusés (20) est mesuré au moyen d'un anneau détecteur (26) qui comprend de préférence une pluralité de segments détecteurs (28) répartis, de préférence de manière équidistante, autour de l'axe du faisceau d'électrons (10).

8. Procédé selon une des revendications précédentes, **caractérisé en ce que** le mouvement relatif est produit par déviation du faisceau d'électrons au moyen d'un champ magnétique (14) ou d'un champ électrique.

9. Procédé selon une des revendications 1 à 8, **caractérisé en ce que** l'on utilise une structure de mesure (16) qui présente une pluralité d'ouvertures circulaires et/ou de surfaces de rétrodiffusion circulaires qui sont disposées à différente distance de la direction d'incidence du faisceau d'électrons non dévié.

10. Procédé selon la revendication 9, **caractérisé en ce que** l'on utilise une structure de mesure (16) dans laquelle les ouvertures et/ou les surfaces de rétrodiffusion sont réparties régulièrement en direction radiale et/ou en direction circonférentielle.

11. Procédé selon la revendication 10, **caractérisé en ce que** l'on utilise une structure de mesure (16) dans laquelle les ouvertures et/ou les surfaces de rétrodiffusion sont orientées de façon que leur axe ou normale passe par le point principal de l'optique (15).

12. Procédé selon une des revendications 1 à 11, **caractérisé en ce que** le mouvement relatif entre faisceau d'électrons et structure de mesure est effectué dans deux directions indépendantes qui se situent essentiellement dans un plan perpendiculaire à la direction d'incidence du faisceau d'électrons (10) non dévié.

13. Procédé selon une des revendications 1 à 12, **caractérisé en ce que** l'on utilise une structure de mesure (16) qui présente une surface plane (20) en matériau faiblement ou pas du tout rétrodiffusant, qui se compose en particulier de graphite, au voisinage des surfaces de rétrodiffusion.

14. Procédé selon une des revendications 1 à 13 pour mesurer l'optique de faisceau d'électrons, **caractérisé en ce que** l'on mesure la section de faisceau du faisceau d'électrons sur une pluralité d'ouvertures et/ou de surfaces de rétrodiffusion circulaires qui présentent une position différente par rapport à la direction d'incidence du faisceau d'électrons non dévié et que l'on compare celle-ci avec une section de faisceau d'un faisceau d'électrons qui est obtenue avec une optique de faisceau d'électrons sans défaut et/ou que l'on mesure les caractéristiques de reproduction de l'optique (15).

15. Procédé selon la revendication 14, **caractérisé en ce que** la structure de mesure est réalisée sous la forme d'une grille, que du fait du mouvement relatif entre faisceau d'électrons et structure de mesure (16), au moins une part notable de la grille est atteinte par le faisceau d'électrons et le courant des électrons rétrodiffusés est converti en une image de la structure de mesure en fonction du mouvement relatif et cette image est comparée avec une image nominale de la structure de mesure qui est obtenue avec une optique de faisceau d'électrons sans défaut.

16. Procédé de compensation des défauts de déviation d'une optique de faisceau d'électrons, dans lequel les caractéristiques de reproduction de l'optique de faisceau d'électrons (15) sont déterminées avec un procédé selon la revendication 14 ou 15 et au moins composant commandable de l'optique est réajusté de façon à minimiser la différence entre image réelle et image nominale de la structure de mesure.

17. Structure de mesure pour mesurer le profil d'intensité d'un faisceau d'électrons (10), en particulier d'un faisceau d'un appareil d'usinage par faisceau d'électrons, et/ou pour mesurer une optique (15) pour un faisceau d'électrons et/ou pour ajuster une optique (15) pour un faisceau d'électrons, **caractérisée en ce qu'**elle présente une base qui présente au moins une ouverture circulaire et/ou une surface de rétrodiffusion circulaire dont la section est inférieure au diamètre du faisceau d'électrons.

18. Structure de mesure selon la revendication 17, **caractérisée en ce que** les axes des ouvertures et/ou la normale aux surfaces de rétrodiffusion passent par un point principal de l'optique.

19. Structure de mesure selon la revendication 17 ou 18, **caractérisée en ce que** les surfaces de rétrodiffusion sont formées par des surfaces d'extrémité d'aiguilles (22) qui sont réalisées de préférence en métal, en particulier en métal lourd comme du tungstène et portées par la base.

20. Structure de mesure selon la revendication 19, dans laquelle l'aiguille (22) est lissée à la meule à son extrémité libre, de préférence essentiellement parallèlement à la surface plane (20) de la base.

21. Structure de mesure selon une des revendications 17 à 20, **caractérisée en ce que** la surface plane (20) de la base est formée d'un matériau faiblement ou pas du tout rétrodiffusant, en particulier de graphite.

22. Structure de mesure selon une des revendications 22 à 26, **caractérisée en ce qu'**elle présente des bandes rétrodiffusantes (46) qui forment une grille, et présente en plus au moins une surface de rétrodiffusion (22) dans chacune des surfaces limitées par les arêtes des mailles de grille.

23. Structure de mesure selon une des revendications 17 à 22, **caractérisée en ce que** les surfaces de rétrodiffusion (22) sont chaque fois situées au centre des surfaces limitées par les lignes de grille.

24. Structure de mesure selon une des revendications 17 à 23, **caractérisée par** une plaque collectrice (50) située derrière elle vu dans la direction du faisceau.

25. Appareil d'usinage par faisceau d'électrons, comprenant :
- une structure de mesure selon une des revendications 17 à 23, et
- un appareil de mesure d'électrons rétrodiffusés (26) disposé avant la structure de mesure dans le chemin du faisceau d'électrons.

26. Appareil d'usinage par faisceau d'électrons selon la revendication 25, **caractérisé en ce que** l'appareil de mesure d'électrons rétrodiffusés comprend un anneau détecteur (26) qui présente de préférence une pluralité de segments détecteurs (28) répartis, de préférence de manière régulière, en direction circonférentielle.

27. Appareil d'usinage par faisceau d'électrons selon la revendication 25 ou 26, **caractérisé par** une optique (15) qui est commandée électroniquement au moyen de signaux de commande d'une unité de commande (30), une unité de mémorisation (30) enregistrant en même temps des signaux de l'appareil de mesure d'électrons rétrodiffusés (26) en fonction des signaux de commande.

28. Appareil d'usinage par faisceau d'électrons selon la revendication 27, **caractérisé en ce que** l'optique (15) avec l'unité de commande (30) ainsi que l'appareil de mesure d'électrons rétrodiffusés (26) sont conçus pour produire une image en microscopie électronique à balayage.

29. Appareil d'usinage par faisceau d'électrons selon la revendication 26, **caractérisé en ce que** dans le cas d'une surface de rétrodiffusion (22) essentiellement ponctuelle de la structure de mesure (16) dans une optique de faisceau d'électrons (15), une lentille de focalisation (12) est placée devant une unité de déviation de faisceau (14) vu dans la direction du faisceau.

30. Appareil d'usinage par faisceau d'électrons selon la revendication 26, **caractérisé en ce que** dans le cas d'une surface de rétrodiffusion (32) étendue de la structure de mesure (16) dans une optique de faisceau d'électrons (15), une lentille de focalisation (12) est placée derrière une unité de déviation de faisceau (14) vu dans la direction du faisceau.
